(19) Europäisches Patentamt
European Patent Office
Office européen des brevets

(11) **EP 3 509 891 B1**

(12) **EUROPÄISCHE PATENTSCHRIFT**

(45) Veröffentlichungstag und Bekanntmachung des Hinweises auf die Patenterteilung:
**12.05.2021 Patentblatt 2021/19**

(51) Int Cl.:
**B60K 37/06** *(2006.01)*     **B60K 35/00** *(2006.01)*
**G06F 3/01** *(2006.01)*     **G06F 3/041** *(2006.01)*

(21) Anmeldenummer: **17757533.9**

(22) Anmeldetag: **23.08.2017**

(86) Internationale Anmeldenummer:
**PCT/EP2017/071241**

(87) Internationale Veröffentlichungsnummer:
**WO 2018/046302 (15.03.2018 Gazette 2018/11)**

(54) **BEDIENEINHEIT FÜR EIN GERÄT, INSBESONDERE FÜR EINE FAHRZEUGKOMPONENTE**

OPERATING UNIT FOR A DEVICE, IN PARTICULAR FOR A VEHICLE COMPONENT

UNITÉ DE COMMANDE D'UN APPAREIL, EN PARTICULIER D'UN COMPOSANT DE VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.09.2016 DE 102016116970**

(43) Veröffentlichungstag der Anmeldung:
**17.07.2019 Patentblatt 2019/29**

(73) Patentinhaber: **Behr-Hella Thermocontrol GmbH**
**70469 Stuttgart (DE)**

(72) Erfinder:
• **SCHWAB, Tobias**
**59557 Lippstadt (DE)**
• **PANKRATZ, Harri**
**59557 Lippstadt (DE)**

(74) Vertreter: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) Entgegenhaltungen:
**US-A1- 2004 075 676     US-A1- 2011 276 878
US-A1- 2013 127 767**

**Beschreibung**

Die Erfindung betrifft eine Bedieneinheit für ein Gerät, bei dem es sich insbesondere um eine Fahrzeugkomponente handelt. Insbesondere betrifft die Erfindung Bedieneinheiten mit aktivem haptischem Feedback mit Kräftekompensation, so dass in Folge des aktiven haptischen Feedback auftretende Schwingungen der Bedieneinheit ausgeglichen bzw. zumindest gedämpft werden.

Display-Baugruppen in Kraftfahrzeugen werden oftmals mit einem aktiven haptischen Feedback (Force Feedback) ausgerüstet. Dabei soll das Auslösen des Feedbacks auf einem mit nicht zu vernachlässigender Masse behafteten Bedienfeld keine unzulässige dynamische Kraftübertragung auf das Fahrzeug erzeugen, da diese je nach Einbausituation zu parasitären Geräuschen bzw. Vibrationen im Fahrzeug führen kann.

Desweiteren soll das haptische Feedback weitgehend unabhängig von der Elastizität der Befestigung im Fahrzeug sein.

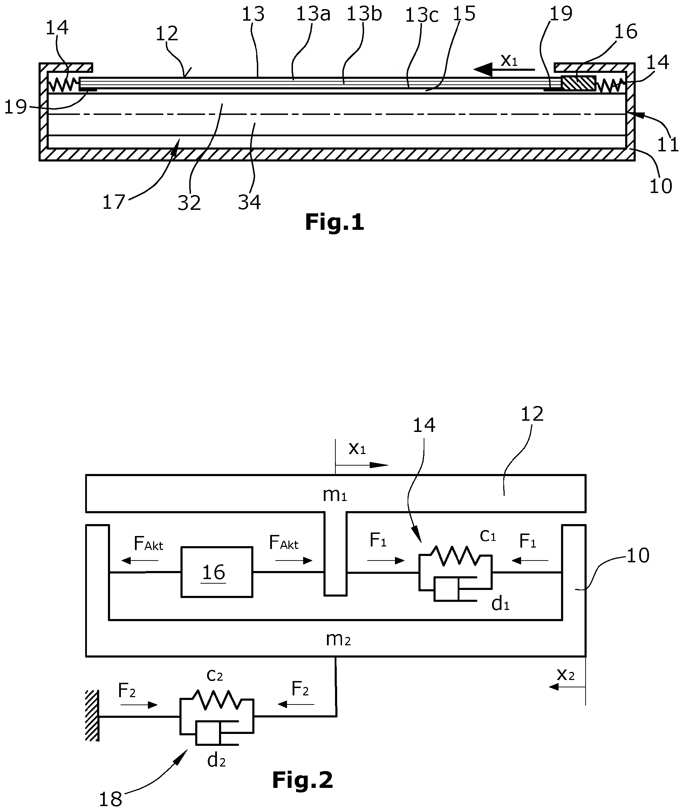

Ein mit einem aktiven haptischen Feedback ausgestattetes Gerät umfasst im Wesentlichen aus einem Bedienfeld (z.B. Display), das über ein Federsystem am Gerätegehäuse elastisch befestigt ist, und einem Aktuator zur Auslenkung des Bedienfeldes. In Fig. 2 sind die wirkenden Kräfte in einem solchen Geräteaufbau dargestellt.

Zur Erzeugung des haptischen Feedbacks wird das Display mit einem bestimmten Wegverlauf $x_1(t)$ aus seiner Ruhelage ausgelenkt. Die Displaybeschleunigung $a_1(t)$ kann hierbei Werte von mehr als 30 m/s$^2$ annehmen, was bei einer bewegten Displaymasse $m_1$ von über 0,5 kg und einer in der Regel kleinen Gehäusemasse $m_2$ zu einer nicht zu vernachlässigenden dynamischen Kraft $F_2(t)$ auf die Gerätebefestigung im Fahrzeug führt.

Bei einer steifen Gerätehalterung bzw. -befestigung (steifes Federsystem $c_2$, $d_2$) kann diese zeitlich schnell veränderliche Kraft unzulässige Geräusche bzw. Vibrationen im Fahrzeug verursachen.

Bei einer weichen Befestigung (weiches Federsystem $c_2$, $d_2$) dagegen erweist sich das Einhalten von Einbautoleranzen des Geräts im Fahrzeug als schwierig. Fernerhin ist die Abstimmung des erforderlichen Aktuatorkraftverlaufs $F_{Akt}(t)$ durch das Vorhandensein eines weiteren Freiheitsgrades, nämlich der Gehäusebewegung $x_2(t)$ und somit auch zusätzlicher Eigenfrequenzen im System, unter Umständen nicht möglich.

Aus US-B-6 822 635 ist ein tragbarer Computer, insbesondere Laptop, bekannt, dessen Eingabepad mit haptischem Feedback versehen ist. Ein Beispiel für die Ausgestaltung eines Touch-Pads ist in DE-U-20 2014 105 258 beschrieben.

Um die beim haptischen Feedback auf die Bedieneinheit und über diese auf die Umgebung wirkenden Kräfte zu minimieren, ist es bekannt, nicht das gesamte berührungsempfindliche Display mechanisch anzuregen, sondern nur einen Teil davon, der insbesondere ein geringes Gewicht aufweisen sollte. In DE-A-10 2005 038 161 ist in dieser Hinsicht beschrieben, von einer Eingabevorrichtung lediglich das Touch-Panel, welches sich oberhalb des eigentlichen Display befindet, mechanisch anzuregen. Das Touch-Panel und das Display sind insoweit als getrennte Einheiten ausgeführt. Allerdings verursachen auch die sich bei mechanischer Anregung des Touch-Panels ergebenden Kräfte Störungen bzw. können zu Geräuschentwicklungen führen und die Umgebung der Bedieneinheit mechanisch anregen, was unerwünscht ist.

Eine Bedieneinheit in Form eines Laptops oder Notebook mit den Merkmalen des Oberbegriffs des Anspruchs 1 ist aus US-A-2011/0276878 bekannt.

Aufgabe der Erfindung ist es, ein hinsichtlich der Entstehung von parasitären Geräuschen bzw. Vibrationen verbessertes Konzept für eine Bedieneinheit mit aktivem haptischen Feedback zu schaffen.

Zur Lösung dieser Aufgabe wird mit der Erfindung eine Bedieneinheit für ein Gerät, z.B. für eine Fahrzeugkomponente, insbesondere Mensch-Maschine-Interface (MMI bzw. HMI) vorgeschlagen, wobei die Bedieneinheit versehen ist mit

- einem Gehäuse, das ein Bedienfeld aufweist sowie zur Befestigung in einer Vorrichtung, insbesondere einer Fahrzeug-Instrumententafel oder Fahrzeug-Mittelkonsole vorgesehen ist,
- wobei das Bedienfeld elastisch an und/oder in dem Gehäuse gelagert ist,
- mindestens einem Aktuator zur bei Erkennung einer Bedienung des Bedienfelds erfolgenden mechanischen Anregung des Bedienfelds und
- einer Anzeigeeinheit mit einer Anzeigefläche,
- wobei das Bedienfeld als Vorderseite eines berührungssensitiven Touch-Panel zur ortsaufgelösten Erkennung einer Berührung des Bedienfelds ausgebildet ist,
- wobei das Touch-Panel von der Anzeigeeinheit getrennt angeordnet ist und
- wobei der mindestens eine Aktuator das Touch-Panel bei einer Erkennung einer Berührung des Bedienfelds mechanisch anregt,
- einem Ausgleichsgewicht, das elastisch im und/oder am Gehäuse und/oder elastisch an dem Touch-Panel gelagert ist, wobei das Ausgleichsgewicht von dem oder von einem Aktuator zum Ausgleichen der bei mechanisch angeregtem Touch-Panel auf das Gehäuse wirkenden Kräfte (d. h. zum im Wesentlichen Unterdrücken einer Bewegung des Gehäuses infolge der Aktivierung des das Touch-Panel mechanisch anregenden Aktuators) mechanisch anregbar ist,
- wobei

  - die Anzeigeeinheit das Ausgleichsgewicht bildet
    und/oder

- die Anzeigeeinheit eine Hinterleuchtungseinheit zum Hinterleuchten der Anzeigeeinheit aufweist, wobei die Hinterleuchtungseinheit getrennt von der Anzeigeeinheit angeordnet ist und das Ausgleichsgewicht bildet.

Gemäß der Erfindung wird das Force Feedback durch mechanische Anregung des Touch-Panel realisiert. Das Touch-Panel bildet das ortsaufgelöst berührungssensitive Bedienfeld der Anzeigeeinheit, das vor der Anzeigefläche angeordnet ist. Erfindungsgemäß ist demnach das Touch-Panel getrennt zur Anzeigeeinheit und relativ zu dieser bewegbar angeordnet. Das Touch-Panel ist selbst bei größerflächigen Displays weiterhin relativ leichtgewichtig, so dass die auf das Gehäuse wirkenden Vibrationen, wie sie bei der mechanischen Anregung des Touch-Panel unweigerlich entstehen, vergleichsweise gering sind.

Zur Reduktion der Auswirkungen der mechanischen Anregung des Touch-Panel auf das Gehäuse und auf die Vorrichtung, in bzw. an der das Gehäuse angeordnet ist, wird gemäß der Erfindung vorgeschlagen, bei Anregung des Touch-Panel ein Ausgleichsgewicht anzuregen, und zwar phasenverschoben, so dass Bewegungen des Gehäuses infolge der Aktivierung des das Touch-Panel mechanisch anregenden Aktuators im Wesentlichen unterdrückt werden. Die Erfindung sieht dabei vor, dass als Ausgleichsgewicht eine Komponente der Bedieneinheit verwendet wird, die unabhängig von der Ausgleichsgewichtfunktion als Komponente der Bedieneinheit erforderlich ist. Hier ist beispielsweise an die Anzeigeeinheit selbst oder aber an eine Hinterleuchtungseinheit für die Anzeigeeinheit oder an beides zu denken.

Die Anzeigeeinheit sorgt im Wesentlichen für das selektive Hindurchlassen bzw. Sperren von einfallendem Licht und/oder Hinterleuchtungslicht. Typischerweise ist die Anzeigeeinheit als LCD-Display ausgeführt. Die Hinterleuchtungseinheit weist die Lichtquellen und, im Regelfall, aber nichts zwangsläufig, auch einen Diffusor zur vergleichmäßigenden Streuung des Hinterleuchtungslichts auf. Sollen beide Einheiten, nämlich Anzeigeeinheit und Hinterleuchtungseinheit als Ausgleichsgewicht genutzt werden, so ist deren phasenverschobene Bewegung zum mechanisch angeregten Touch-Panel auf Grund der Tatsache möglich, dass das Touch-Panel und die Kombination aus Anzeigeeinheit und Hinterleuchtungseinheit getrennte Bauteile sind, die beispielsweise durch einen Lichtspalt (spaltförmiger Abstand) voneinander getrennt sind. Soll nur eine der Komponenten Anzeigeeinheit und Hinterleuchtungseinheit als Ausgleichsgewicht dienen, so müssen Hinterleuchtungseinheit und Anzeigeeinheit getrennt voneinander ausgeführt und eine dieser beiden Einheiten phasenverschoben zum Touch-Panel mechanisch anregbar sein. Sofern die Hinterleuchtungseinheit keine Diffusoreigenschaften aufweist, befindet sich der Diffusor zweckmäßigerweise insbesondere feststehend zwischen der Hinterleuchtungseinheit und der Anzeigeeinheit, z.B. an der Rückseite der Anzeigeeinheit.

In vorteilhafter Weiterbildung der Erfindung und typischerweise ist vorgesehen, dass das Touch-Panel eine Schutzschicht aus insbesondere gehärtetem Glas und eine Sensorschicht, die beispielsweise resistiv, kapazitiv oder optisch arbeitet, sowie zwischen diesen eine lichtdurchlässige Antireflexionsschicht aufweist, die miteinander gebondet sind. Die Antireflexionsschicht kann beispielsweise als Polarisationsfilter und insbesondere als Linear- oder Zirkular-Polarisationsfilter ausgebildet sein.

Insbesondere von Vorteil ist es, wenn das Ausgleichsgewicht um im Wesentlichen 180° phasenverschoben zur Anregungsbewegung des Touch-Panel bewegbar ist, wobei der Bewegungshub des Ausgleichsgewichts unter Berücksichtigung zumindest der Relation der Masse des Touch-Panel zur Masse des Ausgleichsgewichts gewählt ist.

In vorteilhafter Ausgestaltung der Erfindung kann vorgesehen sein, dass das Ausgleichsgewicht vektoriell entgegengesetzt zur Anzeigeeinheit anregbar ist. Es kann ferner von Vorteil sein, wenn die Bewegungshübe von Touch-Panel und Ausgleichsgewicht bei Anregung durch den oder die Aktuatoren ausgelegt sind in Abhängigkeit von der Relation der jeweiligen Massen von Anzeigeeinheit und Hinterleuchtungseinheit und/oder der Relation der Lage der Massenschwerpunkte von Touch-Panel und Ausgleichsgewicht und/oder den Feder-Dämpfungselementen der jeweiligen elastischen Lagerungen von Touch-Panel und Ausgleichsgewicht am Gehäuse und/oder der Größe der vektoriell entgegengesetzt zueinander gerichteten Bewegungshubkomponenten bzw. Bewegungshüben von Touch-Panel und Ausgleichsgewicht.

In weiterer vorteilhafter Ausgestaltung der Erfindung kann vorgesehen sein, dass ein gemeinsamer Aktuator zur Bewegung sowohl des Touch-Panel als auch des Ausgleichsgewichts vorgesehen ist, wobei der Aktuator ein längenveränderbares Stellglied mit zwei voneinander abgewandten Enden aufweist, deren Abstand durch gegensinnige Bewegung veränderbar ist und von denen das eine Ende mit dem Touch-Panel und das andere Ende mit dem Ausgleichsgewicht zwecks mechanischer Anregung dieser beiden Komponenten in Wirkverbindung steht.

Erfindungsgemäß kann vorgesehen sein, dass der oder die Aktuatoren elektromechanisch oder piezoelektrisch arbeitet/arbeiten.

Die Erfindung wird nachfolgend anhand mehrerer Ausführungsbeispiele sowie unter Bezugnahme auf die Zeichnung näher erläutert. Im Einzelnen zeigen dabei:

Fig. 1 ein erstes Ausführungsbeispiel der Erfindung, bei dem das Touch-Panel eines Touch-Screen getrennt vom Display und relativ zu diesem beweglich ausgeführt ist,

Fig. 2    schematisch die bei einer Bedieneinheit mit aktivem haptischen Feed-back auftretenden Kräfte,

Fig. 3    eine schematische Darstellung der auftretenden Kräfte bei erfindungsgemäßer Verwendung eines Gegengewichts als Ausgleichsmasse,

Fig. 4    schematisch eine Konstruktion eines gegenkraftfreien haptischen Feedback bei einer Bedieneinheit,

Fig. 5    eine schematische Darstellung eines mechanischen Aufbaus zur Übertragung eines Impulses auf eine Bedieneroberfläche ohne resultierende Gesamtkräfte bzw. Gesamtimpulse auf die mechanische Halterung gemäß einem weiteren Ausführungsbeispiel der Erfindung,

Fig. 6    eine schematische Darstellung eines dritten Ausführungsbeispiels jedoch mit piezoelektrisch arbeitendem Aktuator,

Fig. 7    eine Erweiterung des Konzepts des Aufbaus nach Fig. 5 um eine Vorrichtung zur Bedienkrafterkennung (Force Sense),

Fig. 8    ein viertes Ausführungsbeispiel der Erfindung und

Fig. 9    schematisch ein fünftes Ausführungsbeispiel der Erfindung.

In Fig. 1 ist ein erstes Ausführungsbeispiel einer erfindungsgemäßen Bedieneinheit gezeigt. Die Bedieneinheit weist ein Gehäuse 10 auf, in dem ein Touch-Screen 11 mit einem Bedienfeld 12 angeordnet ist. Der Touch-Screen 11 weist ein berührungssensitives Touch-Panel 13 auf, das durch einen Luftspalt 15 getrennt von dem Display 17 angeordnet ist. Das Touch-Panel 13 ist bei 14 elastisch an das Gehäuse 10 angebunden, so dass es lateral bzw. dergestalt bewegbar ist, dass es eine laterale Bewegungskomponente aufweist. Mittels eines Aktuators 16, der beispielsweise piezoelektrisch oder elektromechanisch arbeitet, lässt sich das Touch-Panel 13 mechanisch anregen, um bei einer wirksamen Betätigung (Berührung des Touch-Panel und geringfügiges Niederdrücken) das haptische Force Feedback zu erzeugen. Ein oder mehrere Wegsensoren 19 detektieren ein Niederdrücken des Touch-Panel 13 und somit ein wirksames Betätigen der Bedieneinheit (Force Sense). Die insoweit gegebene elastische Lagerung des Touch-Panel 13 in vertikaler Richtung ist weder in Fig. 1 noch in den anderen Figuren gezeigt.

Auf Grund des Luftspaltes 15 lässt sich zunächst das Touch-Panel 13 unabhängig vom feststehend angeordneten Display 17 niederdrücken. Der Aktuator 16 "quittiert" die Betätigung des Touch-Panel 13 taktil für den Benutzer.

Wie in Fig. 1 angedeutet, weist das Touch-Panel 13 beispielsweise einen Drei-Schichten-Aufbau auf, der ein gehärtetes Deckglas bzw. eine Deckschicht 13a, eine Antireflexionsschicht 13b und die eigentliche berührungssensitive Schicht 13c aufweist, die beispielsweise kapazitiv, resistiv oder optisch arbeitet.

Der Vorteil des Aufbaus gemäß Fig. 1 besteht darin, dass die für das Force Feedback mechanisch anzuregende Masse relativ gering ist, so dass mechanische Rückwirkungen auf das Gehäuse und von diesem auf dessen Einbauumgebung (z.B. Instrumententafel, Mittelkonsole) relativ gering sind.

Um diese Rückwirkungen weiter zu reduzieren, bietet es sich an, eine Komponente der Bedieneinheit phasenverschoben zum mechanisch angeregten Touch-Panel 13 anzuregen.

Nachfolgend soll anhand der Fign. 2 bis 4 ganz allgemein auf dieses Konzept des Massenausgleichs bei einer Bedieneinheit mit Force-Feedback eingegangen werden.

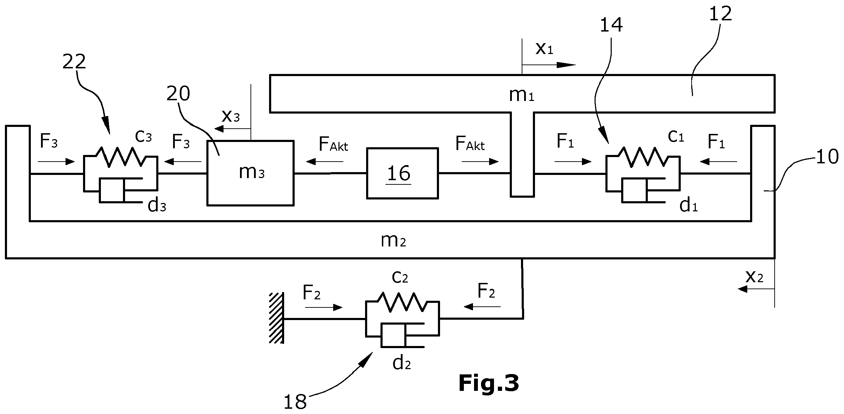

In vorteilhafter Weiterbildung der Erfindung wird die Verwendung einer elastisch gelagerten (siehe Feder-Masse-System 22) beweglichen Gegenmasse 20 zwischen dem Aktuator 16 und dem Gehäuse 10 zum Ausgleich der auf das Gehäuse 10 wirkenden Kräfte vorgeschlagen (Fign. 2 und 3).

Bei entsprechender Auslegung des zusätzlichen Feder-Masse-Systems 22 bzw. $c_3$, $d_3$, $m_3$ kann die auf das Fahrzeug wirkende, resultierende Kraft $F_2(t)$ eliminiert werden (die durch Gravitation entstehenden statischen Kräfte spielen bei der Entstehung von Geräuschen bzw. Vibrationen keine Rolle).

Für eine beliebig vorgegebene Displayauslenkung $x_1(t)$ kann die Auslenkung $x_2(t)$/Bewegung des Gerätegehäuses und somit auch die Kraft $F_2(t)$ auf die Gerätebefestigung unter folgenden Bedingungen eliminiert werden:

$$c_3 = c_1 \frac{m_3}{m_1}, \quad d_3 = d_1 \frac{m_3}{m_1}$$

Daraus ergibt sich die Auslenkung der Gegenmasse 20:

$$x_3(t) = x_1(t) \frac{m_1}{m_3}$$

Unter diesen Bedingungen hat auch die Elastizität der Gerätebefestigung 18 keinen Einfluss auf das haptische Feedback. Die Gegenmasse 20 bzw. $m_3$ ist in der Regel durch die Bauraumvorgaben eingeschränkt und ist kleiner als die Displaymasse $m_1$. Idealerweise kann sie als ein Teil des Aktuators 16 ausgeführt werden.

Die vorliegende Erfindung ermöglicht es

- ein haptisches Feedback auf massebehafteten Oberflächen ohne dynamische Krafteinwirkung auf die Umgebung zu erzeugen.
- ein haptisches Feedback in einem Bediengerät zu erzeugen, das unabhängig von der Elastizität der Gerätebefestigung ist.

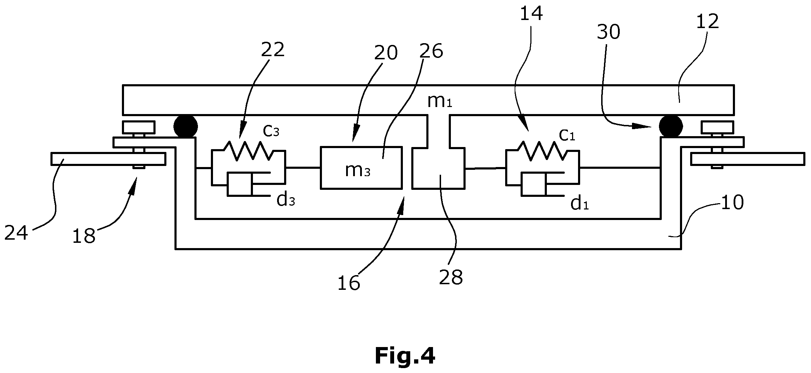

In Fig. 4 ist eine Vorrichtung mit einem gegenkraftfreien haptischen Feedback skizziert.

Im dargestellten Beispiel ist der Aktuator 20 als Zugmagnet ausgebildet und weist ein am Gehäuse 10 elastisch gelagertes Statorblechpaket mit der Aktuatorspule (Stator 26) und einem am Display mit Bedienfeld 12 fest angebundenen Ankerblechpaket (Anker 28) auf. Der Stator 26 bildet die bewegliche Gegenmasse 20. Bei der Einstellung des Luftspalts im Zugmagnet muss die maximale Auslenkung des Displays und des Ausgleichsgewichts 20 zueinander berücksichtigt werden. Der Stator 26 ist elastisch (Feder-Masse-System 22) am Gehäuse 10 gelagert, kann aber auch stattdessen am Bedienfeld 12 elastisch angebunden sein.

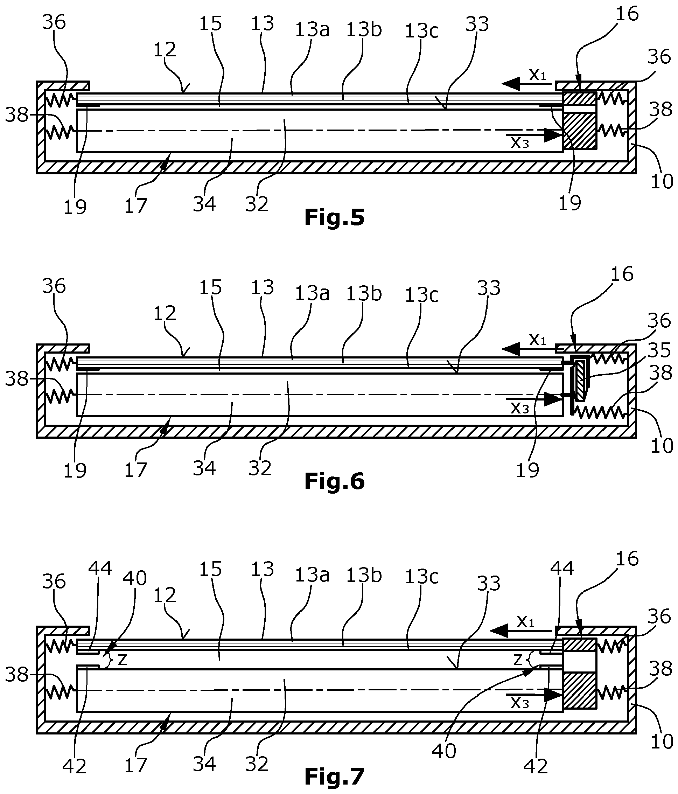

Anhand der Fign. 5 bis 7 werden nachfolgend mögliche mechanische Aufbauten einer Bedieneinheit mit einem Anzeige- und Bedienelement, welches hinterleuchtet ist und bei dem das Touch-Panel 13 beweglich ist, näher erläutert. Soweit in diesen Figuren die gleichen Bezugszeichen wie in den Fign. 1 bis 4 verwendet werden, bezeichnen sie baugleiche oder funktionsgleiche Elemente.

Gemäß Fig. 5 erzeugt der Aktuator 16 nach seiner Aktivierung Kräfte, die zur Beschleunigung und Bewegung von zwei an ihm befestigten, voneinander getrennten Bauteilen, nämlich dem Touch-Panel 13 und dem Display 17, bestehend aus einer (z.B. LCD-)Anzeigeeinheit 32 mit Anzeigefläche 33 und einer Hinterleuchtungseinheit 34 für die Anzeigeeinheit 32 führen. Die Bewegungen von Touch-Panel 13 und Display 17 sind durch $x_1$ und $x_3$ gekennzeichnet. Der Aktuator 16 ist im Wesentlichen dadurch gekennzeichnet, dass er das Touch-Panel 13 und das Display 17 um 180° phasenverschoben gegeneinander auslenkt. Hierfür kann der Aktuator 16 z.B. als Elektromagnet, Piezoelement, etc. ausgelegt sein. Die in Fig. 5 gezeigte Anordnung des Aktuators 16 ist eine mögliche Ausführungsart. Im Allgemeinen ist die Integration des Aktuators 16 lediglich durch das resultierende Auslösen der Bewegungen $x_1$ und $x_3$ von Touch-Panel 13 und Display 17 bestimmt, was z.B. durch die Anordnung des Aktuators 16 unterhalb des Displays 17 erfolgen kann.

In Fig. 6 ist ein Ausführungsbeispiel mit Piezo-Aktuator 16 darstellt. Der Aktuator 16 weist ein piezoelektrisches Material 35 auf, welches sich beim Anlegen einer Spannung mechanisch verformt. Das Touch-Panel 13 und das Display 17 sind mechanisch an unterschiedlichen Seiten des piezoelektrischen Materials 35 des Aktuators 16 angebunden.

Das Touch-Panel 13 weist eine vom Benutzer berührbare Oberfläche, nämlich das Bedienfeld 12 auf.

das Display 17 ist nicht vom Benutzer berührbar und darüber hinaus von der berührbaren Oberfläche des Touch-Panel 13 sowie des Touch-Panel 13 selbst durch den Luftspalt 15 entkoppelt. Der Nutzer spürt die Rückmelde-Bewegung des Touch-Panel 13 nach Anregung durch den Aktuator 16 mittels Übertragung von Kraft, z.B. Impuls, auf das jeweilige Eingabemittel, d.h. beispielsweise den Finger, so dass eine haptische Rückmeldung nach valider Interaktion mit der Bedieneinheit, was durch den/die Wegsensoren 19 erreicht wird, erfolgt.

Eine gesamtimpuls- und gesamtkraftfreie mechanische Halterung im Gehäuse 10 wird erreicht, wenn

- sich das Touch-Panel 13 vektoriell entgegengesetzt zum Display 17 bewegt, z.B. wenn sich das Touch-Panel 13 in positiver X-Richtung und gleichzeitig das Display 17 in negativer X-Richtung bewegt, und
- die Feder-Dämpfungselemente 36 und 38, mit denen das Touch-Panel 13 sowie das Display 17 jeweils elastisch an das Gehäuse 10 angebunden sind, so ausgelegt sind, dass sich die aufgenommenen lokalen Impulse von Touch-Panel 13 und Display 17 in Summe aufheben.

Dieser Ansatz setzt im Allgemeinen Folgendes nicht voraus, schließt es aber auch nicht aus:

- Massengleichheit von Touch-Panel 13 und Display 17,
- Weggleichheit ($x_1$,$x_3$, nach Betrag) von Touch-Panel 13 und Display 17 und
- Gleichheit der Feder-Dämpfungselemente 36,38.

Im Speziellen hat das Bedienelement folgenden Aufbau:

- bewegliches Touch-Panel 13 mit Nutzeroberfläche, z.B. Coverglas mit gebondeter Touchsensorschicht und dazwischen angeordnetem Antireflexionsfilter (Linear- oder Zirkular-Polarisationsfilter)
- LC-Zellen eines LC-Displays eines LCD-Displays 17, aufweisend zwei Linearpolarisatoren, TFT- & Farbfilterglas, LC und alle für dessen Funktion relevanten Komponenten der Anzeigeeinheit 32 und Hinterleuchtungseinheit 34 (Backlight) des LC-Displays mit optischen Diffusorschichten, LEDs und allen relevanten Komponenten.

Im Vergleich zum Stand der Technik von Touch-Screens, bei denen das Touch-Panel 13 und das Display 17 keine Relativbewegungen zueinander ausführen können, ist erfindungsgemäße eine freie Bewegung zwischen beiden Komponenten vorgesehen. Beide Komponenten erfüllen ihre volle Funktionalität, wie es von Touch-Screens bekannt ist. Weiterhin sollten die Relativbewegungen von Touch-Panel 13 und Display 17 so gering sein, dass keine negativen optischen Effekte, z. B. durch Lichtaustritt oder Abschottung von Licht, zu beobachten sind (Bewegungen jeweils kleiner als 1 mm). Der Eintrag von Staubund/oder Wasser ins Display wird durch eine elastische Einfassung (z.B. weiche Gummierung) verhindert. Die elastische Einfassung verhindert weiterhin den Austritt von Licht des Displays 17.

Im Vergleich zum Stand der Technik für haptische Rückmeldungen eines Geräts mit Anzeigeelement (Display), bei denen der gesamte Touch-Screen bewegt wird, reduziert sich mit der Erfindung die zu bewegende Masse mit Anbindung zur Benutzeroberfläche auf das Gewicht des Touch-Panel 13 und gegebenenfalls der an dieses mechanisch angebundenen Bauteile. Weiterhin dient das Display 17, und zwar dessen Anzeigeeinheit 32 und/oder dessen Hinterleuchtungseinheit 34, als Ausgleichsgewicht 20 für das Touch-Panel 13 und somit als entscheidendes Bauteil zur gesamtimpulsfreien Auslegung des Gesamtgeräts. Im Besonderen werden keine weiteren Gegengewichte zur Aufhebung des Gesamtpulses benötigt und somit das Systemgewicht insgesamt reduziert.

Durch die geringere Masse der mit der Nutzeroberfläche in Verbindung stehenden Komponenten wird entweder ein stärkeres haptisches Feedback für den Nutzer bei gleichem Aktuator 16 oder die Auslegung eines kleineren Aktuators 16 bei gleichem, spürbarem Feedback ermöglicht.

Zusammenfassend wird durch die hier beschriebene Variante der Erfindung ein haptisches Feedback auf der Nutzeroberfläche erreicht, und zwar ohne Impuls- und Kraftübertrag auf die Geräteumgebung erreicht.

Fig. 7 zeigt eine Erweiterung des Konzepts nach Fign. 5 und 6 um die Erkennung der Bedienkraft bei der Interaktion des Nutzers mit dem Touch-Panel 13 (Force Sense).

Zur Erkennung der Bedienkraft wird eine z.B. kapazitiv, resistiv, induktiv oder optisch arbeitende Abstandssensorik 40 aus z.B. mehreren Paaren von optischen Sendern 42 und Empfängern 44 vorgesehen. Unter Einwirkung des Nutzers findet bei der manuellen Betätigung des Touch-Panel 13 des Touch-Screens 11 eine Änderung des Relativabstands z zwischen dem Touch-Panel 13 und dem Display 17 statt, so dass eine oder mehrere Systemobservablen der Sender 42 und Empfänger 44 zur Detektion der Änderung genutzt werden können.

Die Integration der Abstandssensorik 40 für den genannten speziellen Touch-Screen 11 erfolgt z.B. in den jeweiligen Einfassungen (Rahmen) des Touch-Sreen 11.

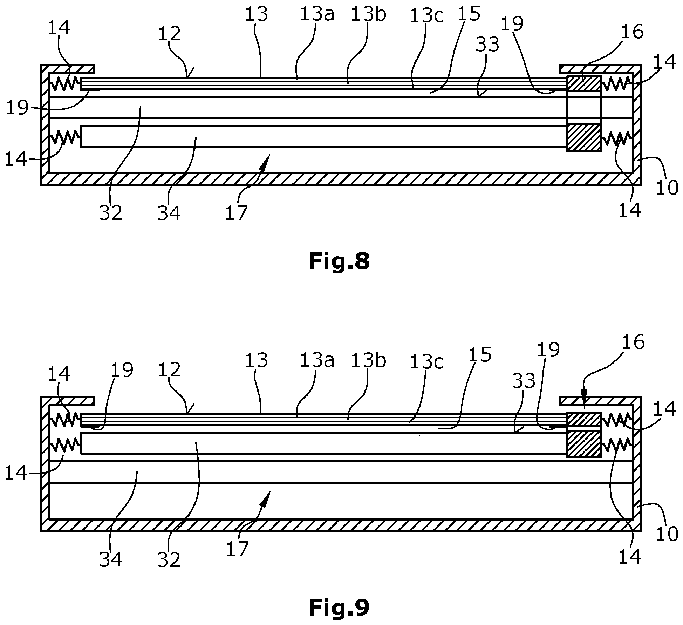

In den Fign. 8 und 9 sind zwei weitere Ausführungsbeispiele der Erfindung schematisch gezeigt. Während bei den Ausführungsbeispielen nach den Fign. 5 bis 7 das Display 17 insgesamt, also die Baugruppe bestehend aus Anzeigeeinheit 32 und Hinterleuchtungseinheit 34 als Ausgleichsgewicht 20 genutzt wird, wird gemäß Fig. 8 als Ausgleichsgewicht 20 lediglich die Hinterleuchtungseinheit 34 des Displays 17 und gemäß Fig. 9 lediglich die Anzeigeeinheit 32 des Displays 17 genutzt. In beiden Fällen bedeutet dies, dass die Anzeigeeinheit 32 und die Hinterleuchtungseinheit 34 getrennt voneinander ausgeführt sind, also nicht untereinander verbunden sind. Jeweils eine dieser beiden Einheiten ist fest im Gehäuse 10 angeordnet, während die andere Einheit bewegbar angeordnet ist.

## Bezugszeichenliste

10 Gehäuse
11 Touch-Screen
12 Bedienfeld
13 Touch-Panel
13a Deckschicht des Touch-Panel
13b Antireflexionsschicht des Touch-Panel
13c berührungssensitive Schicht des Touch-Panel
14 elastische Anbindung des Bedienfelds am Gehäuse
15 Luftspalt
16 Aktuator
17 Display
18 Anbindung des Gehäuses ans Fahrzeug
19 Wegsensor
20 Ausgleichsgewicht
22 elastische Anbindung des Ausgleichsgewichts am Gehäuse und/oder am Bedienfeld
24 Fahrzeug bzw. Instrumententafel des Fahrzeugs
26 Stator des als Aktuator ausgeführten Zugmagnets
28 Anker des Zugmagnets
30 Bedienfeldführung für die Bewegung bei haptischer Rückmeldung
32 Anzeigeeinheit
33 Anzeigefläche
34 Hinterleuchtungseinheit
35 piezoelektrisches Material
36 Feder-Dämpfungselement
38 Feder-Dämpfungselement
40 Abstandssensorik
42 Sender der Abstandssensorik
44 Empfänger der Abstandssensorik
$m_1$ Masse des Bedienfelds
$x_1(t)$ Auslenkung des Bedienfelds
$F_{Akt}(t)$ Aktuatorkraftverlauf
$F_1(t)$ auf das Gehäuse wirkende Kraft des Bedienfelds bei Anregung desselben ($F_1(t) = F_{Akt} - m_1 x a_1$)
$c_1$ Federkonstante der elastischen Anbindung des Bedienfelds am Gehäuse
$d_1$ Dämpfung der elastischen Anbindung des Bedienfelds am Gehäuse
$m_2$ Masse des Gehäuses
$x_2(t)$ Auslenkung des Gehäuses in Folge der durch das mechanisch angeregte Bedienfeld ausgeübten Kraft
$F_2(t)$ auf die Gehäusebefestigung wirkende Kraft

$m_3$ Masse des Ausgleichsgewichts

$x_3(t)$ Auslenkung des Ausgleichsgewichts

$F_3$ durch das Ausgleichsgewicht auf das Gehäuse wirkende Kraft

$c_3$ Federkonstante der elastischen Anbindung des Ausgleichsgewichts am Gehäuse

$d_3$ Dämpfung der elastischen Anbindung des Ausgleichsgewichts am Gehäuse

$z$ Abstand zwischen Anzeigeeinheit und Hinterleuchtungseinheit

**Patentansprüche**

1. Bedieneinheit für ein Gerät, z.B. für eine Fahrzeugkomponente, insbesondere Mensch-Maschine-Interface (MMI bzw. HMI), mit

   - einem Gehäuse (10), das ein Bedienfeld (12) aufweist sowie zur Befestigung in einer Vorrichtung, insbesondere einer Fahrzeug-Instrumententafel oder Fahrzeug-Mittelkonsole vorgesehen ist,
   - wobei das Bedienfeld (12) elastisch an und/oder in dem Gehäuse (10) gelagert ist,
   - mindestens einem Aktuator (16) zur bei Erkennung einer Bedienung des Bedienfelds (12) erfolgenden mechanischen Anregung des Bedienfelds (12),
   - einer Anzeigeeinheit (32) mit einer Anzeigefläche (33),
   - wobei das Bedienfeld (12) als Vorderseite eines berührungssensitiven Touch-Panel (13) zur ortsaufgelösten Erkennung einer Berührung des Bedienfelds (12) ausgebildet ist und
   - wobei der mindestens eine Aktuator (16) das Touch-Panel (13) bei einer Erkennung einer Berührung des Bedienfelds (12) mechanisch anregt, und
   - einem Ausgleichsgewicht (20), das elastisch im und/oder am Gehäuse (10) und/oder elastisch an dem Touch-Panel (13) gelagert ist, wobei das Ausgleichsgewicht (20) von dem oder von einem Aktuator (16) zum Ausgleichen der bei mechanisch angeregtem Touch-Panel (13) auf das Gehäuse (10) wirkenden Kräfte mechanisch anregbar ist,

   **dadurch gekennzeichnet,**

   - **dass** das Touch-Panel (13) von der Anzeigeeinheit (32) getrennt angeordnet ist und
   - **dass**

     - die Anzeigeeinheit (32) das Ausgleichsgewicht (20) bildet und/oder
     - die Anzeigeeinheit (32) eine Hinterleuchtungseinheit (34) zum Hinterleuchten der Anzeigeeinheit (32) aufweist, wobei die Hinterleuchtungseinheit (34) getrennt von der Anzeigeeinheit (32) angeordnet ist und das Ausgleichsgewicht (20) bildet.

2. Bedieneinheit nach Anspruch 1, **dadurch gekennzeichnet, dass** das Ausgleichsgewicht (20) vektoriell entgegengesetzt zum Touch-Panel (13) anregbar ist.

3. Bedieneinheit nach Anspruch 1, **dadurch gekennzeichnet, dass** die Bewegungshübe des Touch-Panel (13) und des Ausgleichsgewichts (20) bei Anregung durch den oder die Aktuatoren (16) ausgelegt/bestimmt sind in Abhängigkeit von der Relation der jeweiligen Massen von Touch-Panel (13) und Ausgleichsgewicht (20) und/oder der Relation der Lage der Massenschwerpunkte von Touch-Panel (13) und Ausgleichsgewicht (20) und/oder den Feder-Dämpfungselementen (36,38) der jeweiligen elastischen Lagerungen von Touch-Panel (13) und Ausgleichsgewicht (20) am Gehäuse (10) und/oder der Größe der vektoriell entgegengesetzt zueinander gerichteten Bewegungshubkomponenten bzw. Bewegungshübe von Touch-Panel (13) und Ausgleichsgewicht (20).

4. Bedieneinheit nach einem der Ansprüche 1 bis 3, **dadurch gekennzeichnet, dass** ein gemeinsamer Aktuator (16) zur mechanischen Anregung sowohl des Touch-Panel (13) als auch des Ausgleichsgewichts (20) vorgesehen ist, wobei der Aktuator (16) ein längenveränderbares Stellglied mit zwei voneinander abgewandten Enden aufweist, deren Abstand durch gegensinnige Bewegung veränderbar ist und von denen das eine Ende mit dem Touch-Panel (13) und das andere Ende mit dem Ausgleichsgewicht (20) zwecks mechanischer Anregung von Touch-Panel (13) und Ausgleichsgewicht (20) in Wirkverbindung steht, oder wobei der Aktuator (16) ein piezokeramisches Element aufweist.

5. Bedieneinheit nach einem der Ansprüche 1 bis 4, **gekennzeichnet durch** einen Wegsensor (19) zur Erkennung einer Betätigungsbewegung des Bedienfelds (12) bei Ausübung einer manuellen Andrückkraft auf das Touch-Panel (13).

6. Bedieneinheit nach Anspruch 1, **dadurch gekennzeichnet, dass** das Touch-Panel (13) eine Schutzschicht (13a) und eine Sensorschicht (13c) sowie zwischen diesen eine lichtdurchlässige Antireflexionsschicht (13b) aufweist, die miteinander gebondet sind, und/oder dass das Touch-Panel (13) eine resistiv, kapazitiv oder optisch arbeitende Näherungs- und/oder Berührungssensorik aufweist, insbesondere in Form eines Polarisationsfilters, wie z.B. eines Linear- oder Zirkular-Polarisationsfilters.

**Claims**

1. An operating unit for a device, e.g. for a vehicle component, in particular a man-machine interface (MMI or HMI), comprising

   - a housing (10) that has a control panel (12) and that is provided for attaching in an apparatus, in particular a vehicle dashboard or vehicle center console,
   - wherein the control panel (12) is mounted elastically at and/or in the housing (10),
   - at least one actuator (15) for mechanically exciting the control panel (12) upon detection of an operation of the control panel (12),
   - a display unit (32) having a display surface (33),
   - the control panel (12) forming the front side of a touch-sensitive touch panel (13) for spatially resolved detection of a touch of the control panel (12),
   - wherein the at least one actuator (16) mechanically excites the touch panel (12) when touching of the control panel (12) is detected, and
   - a compensation weight (20) that is elastically mounted in and/or at the housing (10) and/or is elastically mounted at the touch panel (13), wherein the compensation weight (20) is mechanically excitable by the actuator (15) or by an actuator for compensating the forces acting on the housing (10) when the touch panel (13) is mechanically excited,

   **characterized in that**

   - the touch panel (13) is arranged separated from the display unit (32) and,
   - **in that**

      - the display unit (32) forms the compensation weight (20)
      and/or
      - the display unit (32) has a backlight unit (34) for backlighting the display unit (32), wherein the backlight unit (34) is arranged separated from the display unit (32) and forms the compensation weight (20).

2. The operating unit according to claim 1, **characterized in that** the compensation weight (20) is excitable vectorially opposite to the touch panel (13).

3. The operating unit according to claim 1, **characterized in that** the movement strokes of the touch panel (13) and of the compensation weight (20) when excited by the actuator(s) (16) are designed/determined as a function of the ratio of the specific masses of the touch panel (13) and the compensation weight (20) and/or the relationship between the position of the centers of mass of the touch panel (13) and the compensation weight (20) and/or the spring damping elements (36, 38) of the specific elastic bearings of the touch panel (13) and the compensation weight (20) at the housing (10) and/or the size of the mutual vectorially opposed movement stroke components or movement strokes of the touch panel (13) and the compensation weight (20).

4. The operating unit according to one of claims 1 to 3, **characterized in that** a common actuator (16) for mechanical excitation of both the touch panel (13) and the compensation weight (20) is provided, wherein the actuator (16) has an actuator element, the length of which is variable and which has two ends facing away from one another, the distance between the ends being variable by opposing movement, and of which the one end is mechanically linked to the touch panel (13) and the other end is mechanically linked to the compensation weight (20) for the purpose of mechanically exciting the touch panel (13) and the compensation weight (20), or wherein the actuator (16) has a piezoceramic element.

5. The operating unit according to one of claims 1 to 4, **characterized by** a path sensor (19) for detecting an actuation movement of the control panel 12) when a manual pressure is exerted on the touch panel (13).

6. The operating unit according to claim 1, **characterized in that** the touch panel (13) has a protective layer (13a) and a sensor layer (13c), and has a light-permeable antireflection layer (13b) therebetween, these being bonded to one another, and/or **in that** the touch panel (13) has a proximity and/or touch sensor system that works in a resistive, capacitive, or optical manner, the latter in particular in the form of a polarization filter, such as e.g. a linear or circular polarization filter.

**Revendications**

1. Unité de commande pour un appareil, par exemple pour un composant de véhicule, en particulier une interface homme-machine (IHM), dotée

   - d'un boîtier (10) comportant un champ de commande (12) et étant prévu pour être fixé dans un dispositif, en particulier un tableau de bord de véhicule ou une console centrale de véhicule,
   - dans laquelle le champ de commande (12) est disposé élastiquement sur et/ou dans le boîtier (10),
   - d'au moins un actionneur (16) permettant une excitation mécanique subséquente du champ de commande (12) lorsqu'une commande du champ de commande (12) est reconnue,

- d'une unité d'affichage (32) dotée d'une surface d'affichage (33),
- dans laquelle le champ de commande (12) est réalisé comme face avant d'un panneau tactile sensible au toucher (13) permettant une reconnaissance spatialement résolue d'un toucher du champ de commande (12) et
- dans laquelle l'au moins un actionneur (16) excite mécaniquement le panneau tactile (13) lors d'une reconnaissance d'un toucher du champ de commande (12), et
- d'un contrepoids (20), lequel est disposé élastiquement dans et/ou sur le boîtier (10) et/ou disposé élastiquement sur le panneau tactile (13), dans laquelle le contrepoids (20) est mécaniquement excitable par le ou par un actionneur (16) afin de compenser les forces s'exerçant sur le boîtier (10) lorsque le panneau tactile (13) est excité mécaniquement,

**caractérisée**

- **en ce que** le panneau tactile (13) est séparé de l'unité d'affichage (32) et
- **en ce que**

- l'unité d'affichage (32) forme le contrepoids (20) et/ou
- l'unité d'affichage (32) comporte une unité de rétroéclairage (34) permettant le rétroéclairage de l'unité d'affichage (32), dans laquelle l'unité de rétroéclairage (34) est séparée de l'unité d'affichage (32) et forme le contrepoids (20).

2. Unité de commande selon la revendication 1, **caractérisée en ce que** le contrepoids (20) est excitable de manière vectoriellement inverse par rapport au panneau tactile (13).

3. Unité de commande selon la revendication 1, **caractérisée en ce que** les courses du panneau tactile (13) et du contrepoids (20) lors de l'excitation par le ou les actionneurs (16) sont configurées/déterminées en fonction de la relation des masses respectives du panneau tactile (13) et du contrepoids (20) et/ou de la relation des positions des centres de gravité du panneau tactile (13) et du contrepoids (20) et/ou des éléments amortisseurs à ressort (36, 38) des logements élastiques respectifs du panneau tactile (13) et du contrepoids (20) sur le boîtier (10) et/ou de la grandeur des courses ou des composantes de course dirigées de manière vectoriellement inverse l'une par rapport à l'autre du panneau tactile (13) et du contrepoids (20).

4. Unité de commande selon l'une des revendications 1 à 3, **caractérisée en ce qu'**un même actionneur (16) est prévu pour exciter mécaniquement aussi bien le panneau tactile (13) que le contrepoids (20), dans laquelle l'actionneur (16) comporte un vérin variable en longueur avec deux extrémités se détournant l'une de l'autre, dont l'écart est variable par mouvement en sens opposé et desquelles l'une extrémité est reliée de manière opérante au panneau tactile (13) et l'autre extrémité est reliée de manière opérante au contrepoids (20) en vue de l'excitation mécanique du panneau tactile (13) et du contrepoids (20), ou dans laquelle l'actionneur (16) comporte un élément piézocéramique.

5. Unité de commande selon l'une des revendications 1 à 4, **caractérisée par** un capteur de mouvement (19) permettant de reconnaître un mouvement d'actionnement du champ de commande (12) lors de l'exercice d'une force de pression manuelle sur le panneau tactile (13).

6. Unité de commande selon la revendication 1, **caractérisée en ce que** le panneau tactile (13) comporte une couche protectrice (13a) et une couche de capteurs (13c) ainsi qu'une couche antireflets (13b) translucide entre celles-ci, lesquelles sont liées l'une à l'autre, et/ou **en ce que** le panneau tactile (13) comporte un système de capteurs de contact et/ou de proximité à fonctionnement résistif, capacitif ou optique, en particulier sous forme d'un filtre de polarisation, comme par exemple un filtre de polarisation linéaire ou circulaire.

**Fig.1**

**Fig.2**

Fig.3

**Fig.4**

**Fig.5**

**Fig.6**

**Fig.7**

EP 3 509 891 B1

**Fig.8**

**Fig.9**

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6822635 B
- DE 202014105258 U
- DE 102005038161 A
- US 20110276878 A